# EUROPEAN PATENT APPLICATION

(11) **EP 2 327 811 A1**
(43) Date of publication of application: **01.06.2011**
(21) Application number: 09815935.3
(22) Date of filing: 25.02.2009
(51) Int. Cl.: C23C 16/54, C23C 16/50, C23C 16/515

(54) **FILM FORMING APPARATUS**

(30) Priority: 26.09.2008 JP 2008247728
(71) Applicant: NGK Insulators, Ltd., Nagoya-city, Aichi 467-8530 (JP)
(72) Inventor: SAITO, Takao, Nagoya-city Aichi 467-8530 (JP); TERAZAWA, Tatsuya, Nagoya-city Aichi 467-8530 (JP)
(74) Representative: Paget, Hugh Charles Edward
(86) International application number: PCT/JP2009/053458
(87) International publication number: WO 2010/035516

(57) **Abstract**

There is provided film deposition units 54 each including two electrodes, each film deposition unit 54 being configured to generate a plasma between the two electrodes to cover substrates 90 with DLC films, a chamber 12 in which the plural film deposition units 54 are arranged, and a pulsed power supply 60 including electric circuits 62 that are arranged for the respective film deposition units 54, the electric circuits 62 applying a DC pulse voltage between a support electrode 51 and a counter electrode 52 of each of the film deposition units 54.

## Description

### Technical Field

The present invention relates to a film deposition apparatus.

### Background Art

Hitherto, a discharge plasma treatment apparatus including a voltage application electrode covered with a solid dielectric material and a counter electrode facing the voltage application electrode has been known, the discharge plasma treatment apparatus being configured to perform treatment by feeding a treatment gas into a gap between the electrodes and bringing a workpiece into contact with a glow discharge plasma generated by a dielectric barrier discharge. For example, in a discharge plasma treatment apparatus described in Patent Document 1, three discharge-plasma-generating units are arranged, each of the units being configured to feed a treatment gas into a gap between two electrodes, in which at least one electrode is provided with a solid dielectric material, and then apply an electric field to generate a plasma. In the three discharge-plasma-generating units, a pulse voltage is applied by one control unit.
Patent Document 1: Japanese Patent No. 3914093

### Disclosure of Invention

Meanwhile, there is a demand for mass production of diamond-like carbon (DLC) films by forming a hydrocarbon gas formed into a plasma and depositing the DLC films on a plurality of workpieces in one operation. In this case, it is conceivable that the discharge plasma treatment apparatus described in Patent Document 1 is used. A DLC film is formed by the transfer of ions in a plasma. Thus, the use of an electrode covered with a solid dielectric material fails to form a DLC film because ions are not transferred. In the case where an electrode is not covered with a solid dielectric material, an arc discharge is highly likely to occur between the electrodes or between a workpiece and the electrode. In particular, in the case where a workpiece is composed of a material having a low volume resistivity (e.g., a metal material having a lower volume resistivity than silicon), an arc discharge occurs readily between the workpiece and the electrode. The occurrence of the arc discharge can cause damage to a DLC film being formed between the electrodes where the arc discharge has occurred. Furthermore, a treatment gas cannot be formed into a plasma between the other electrodes to which an electric field is applied by the same control unit, thereby failing to form a DLC film. It is thus difficult to perform treatment in high yield when a plurality of workpieces are treated by simultaneously forming DLC films on the plural workpieces.

The present invention has been made in light of the circumstances described above. It is a main object of the invention to provide a film deposition apparatus capable of mass-producing products in high yield, each of the products being produced by covering a workpiece composed of a metal material having a lower volume resistivity than silicon with a film formed together with the transfer of ions in a plasma.

To achieve the object, the present invention employs a measure described below.

A film deposition apparatus of the present invention is configured to cover a plurality of workpieces composed of a metal material having a lower volume resistivity than silicon with predetermined films that are formed together with the transfer of ions in a plasma, the apparatus including: film deposition units each including a support electrode that supports the respective workpieeces and serves as one electrode for generating the plasma, and including a counter electrode that is provided apart from the support electrode to face the support electrode and serves as the other electrode for generating the plasma; an enclosed space in which the plural film deposition units are arranged; and individual power supplies that are provided for the respective film deposition units and apply a voltage between the support electrodes and the counter electrodes.

In this film deposition apparatus, the individual power supplies are provided for the respective film deposition units in the enclosed space. When predetermined films are formed on the workpieces each composed of a metal material having a lower volume resistivity than silicon, a voltage is applied between the support electrodes and the counter electrodes by the individual power supplies while the workpieces are being supported on the support electrodes. As described above, the individual film deposition units are provided with the respective individual power supplies. Thus, even if an arc discharge occurs in any film deposition unit during the formation of a predetermined film, the application of the voltage to the other film deposition units is maintained; hence, it is possible to continue the film deposition. Therefore, it is possible to mass-produce in high yield the products that are produced by covering the workpiece with the predetermined film formed together with the transfer of the ions in the plasma. Here, examples of the predetermined film include the DLC film, a boron nitride (BN) film, and a cubic boron nitride (c-BN) film. The DLC film is a film also referred to as a hard carbon film and an amorphous carbon film.

Preferably, the film deposition apparatus of the present invention further includes a pressure regulating unit for regulating a pressure in the enclosed space, in which the individual power supplies apply a voltage between the support electrodes and the counter electrodes of the film deposition units to generate plasmas while the pressure in the enclosed space is regulated in the range of 10 hPa to atmospheric pressure (more preferably, 100 hPa to atmospheric pressure) by the pressure regulating unit, so that the plural workpieces are covered with the predetermined films. In the case where the predetermined films are formed at a pressure of 10 hPa to atmospheric pressure, the film deposition rate is higher than that at a pressure of less than 10 hPa. It is thus possible to cover a larger number of the workpieces per unit time. In the case where the predetermined films are formed at a pressure of 100 hPa to atmospheric pressure, the film deposition rate is higher than that at a pressure of less than 100 hPa. It is thus possible to cover a larger number of the workpieces per unit time. Furthermore, an arc discharge is likely to occur compared with at a pressure of less than 100 hPa; hence, the present invention is can be applied with great significance. In the case where the predetermined films are formed at a pressure of 100 hPa to atmospheric pressure, the application of an electric power of 75 W/cm² or more per unit area of each of the counter electrodes to the film deposition units is preferred because of an increase in film deposition rate. In the case where the predetermined films are formed at a pressure of 10 hPa to atmospheric pressure, the application of an electric power of 150 W/cm² or more per unit area of each of the counter electrodes to the film deposition units is preferred because of an increase in film deposition rate.

In the film deposition apparatus of the present invention, each of the counter electrodes of the film deposition units may have a nozzle configured to eject a gas, which is a source of the predetermined film, toward a corresponding one of the workpieces. In this case, each of the counter electrodes of the film deposition units preferably has a nozzle with a diameter of 1 mm to 4 mm. A diameter of the nozzle of less than 1 mm results in the limitation of the flow rate of the gas to reduce the film deposition rate, which is not suitable for mass production, and thus is not preferred. A diameter exceeding 4 mm increases variations in in-plane thickness distribution of the predetermined film and thus is not preferred.

In the film deposition apparatus of the present invention, each of the support electrodes of the film deposition units preferably supports a corresponding one of workpieces in such a manner that the distance between each of the workpieces and a corresponding one of counter electrodes is in the range of 1 mm to 20 mm. At a distance of less than 1 mm, a glow discharge occurs at a low voltage but shifts to an arc discharge, failing to form a film, which is not preferred. At a distance exceeding 20 mm, a glow discharge does not occur readily and thus is not preferred.

In the film deposition apparatus of the present invention, the workpieces may be composed of an iron-based material. Silicon has a volume resistivity of 10⁻² to 10⁶ Ω·cm.
In contrast, an iron-based material has a volume resistivity of 10⁻⁴ to 10⁻⁶ Ω·cm. Thus, the use of a workpiece composed of an iron-based material is more liable to cause an arc discharge than the use of a workpiece composed of silicon. Therefore, the present invention can be applied with great significance. A preferred iron-based material is a stainless-steel (SUS) material, a die steel (SKD) material, or a high-speed steel (SKH) material. Examples of the SUS material includes iron-chromium-based SUS410, SUS430, and SUS440. Examples of the SKD material include SKD11 and SKD61. Examples of the SKH material include SKH2, SKH10, SKH51, and SKH55. It should, of course, be understood that the invention is applied to a workpiece composed of a material mainly containing aluminum and a workpiece composed of a material mainly containing copper.

In the film deposition apparatus of the present invention, the individual power supplies may apply a DC pulse voltage between the support electrodes and the counter electrodes. The individual power supplies reduce the possibility of the occurrence of an arc discharge, thereby forming the predetermined films on the plural workpieces in higher yield.

### Brief Description of Drawings

Fig. 1 schematically illustrates the configuration of a DLC-film deposition apparatus 10;
Fig. 2 illustrates the configuration of an electric circuit 62 of a pulsed power supply unit 60;
Fig. 3 is an explanatory drawing showing operation waveforms of current and voltage of components; and
Fig. 4 schematically illustrates the configuration of a DLC-film deposition apparatus 110.

### Best Mode for Carrying Out the Invention

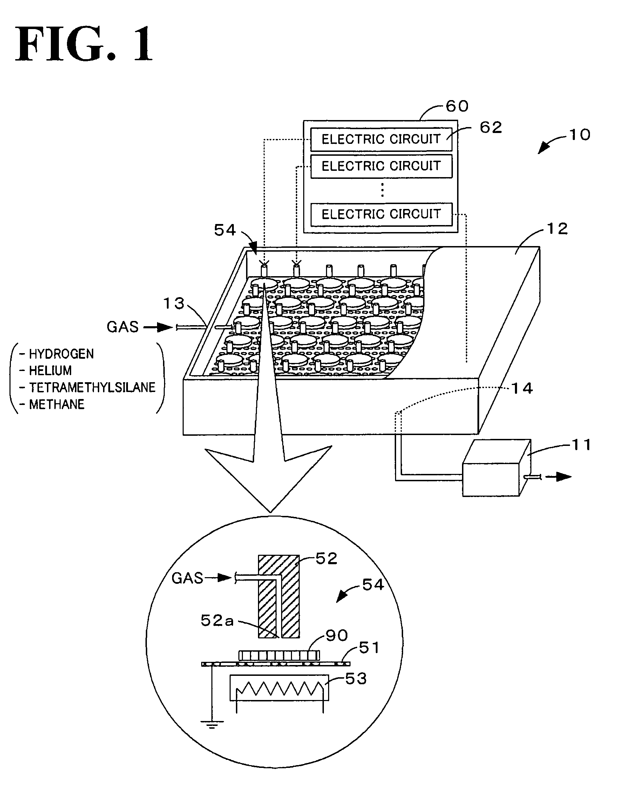

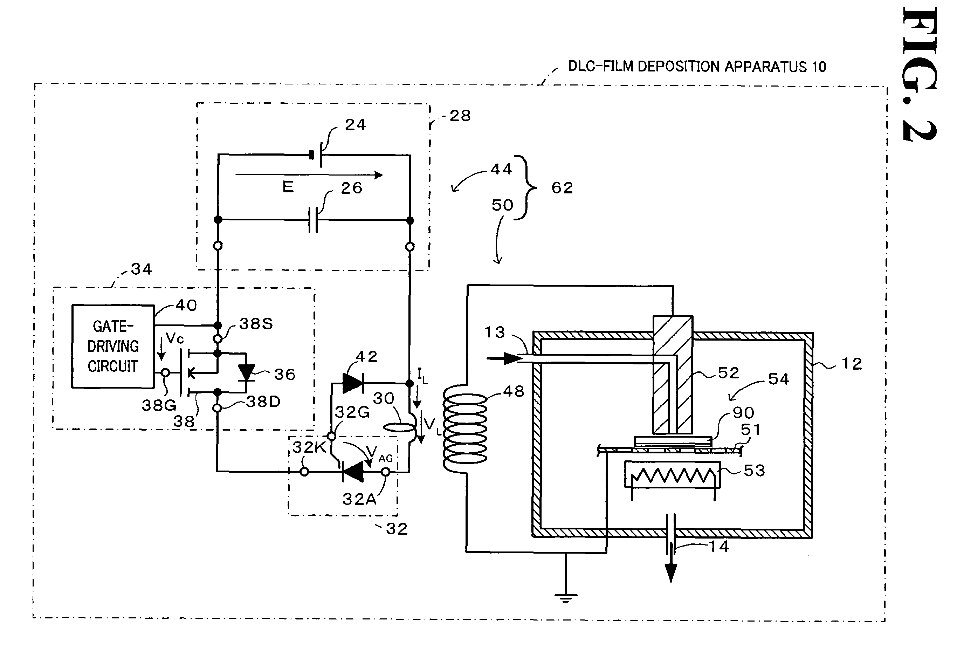

Embodiments of the present invention will be described below with reference to the drawings. Fig. 1 schematically illustrates the configuration of a DLC-film deposition apparatus 10 according to an embodiment of the present invention. Fig. 2 illustrates the configuration of an electric circuit 62 of a pulsed power supply unit 60.

The DLC-film deposition apparatus 10 is an apparatus configured to simultaneously cover a plurality of substrates 90 composed of an iron-based material (e.g., a stainless-steel (SUS) material, a die steel (SKD) material, or a high-speed steel (SKH) material) having a lower volume resistivity than silicon with DLC films that are formed with the transfer of ions in a plasma at a pressure of 100 hPa to atmospheric pressure. The DLC-film deposition apparatus includes a plurality of film deposition units 54, a chamber 12 where the film deposition units 54 are arranged, a pulsed power supply 60 including electric circuits 62 arranged to correspond to the respective film deposition units 54, and a vacuum pump 11 that regulates the pressure in the chamber 12.

Each of the film deposition units 54 includes a support electrode 51 that supports each of the substrates 90 from underneath and is grounded to serve as one electrode configured to generate a plasma, a counter electrode 52 that is located above and apart from the support electrode 51 to be faced with the support electrode 51 and serves as the other electrode configured to generate the plasma, and a ceramic heater 53 configured to heat the corresponding substrate 90 by infrared radiation from underneath. Note that a stage heater or a sheath heater that directly heat the substrate 90 may be used in place of the ceramic heater. The support electrode 51 is formed of what is called a perforated metal member, which has a plurality of holes. The support electrode 51 is provided with a leg so as to be apart from the inner bottom of the chamber 12 and has a structure that allows a gas to flow downward through the plurality of holes. The counter electrode 52 is formed of a cylindrical member. The counter electrode 52 has a nozzle 52a which is configured to eject various gases toward the upper surface of a corresponding one of the substrates 90 and which has a diameter of 1 mm to 4 mm. The distance between the support electrode 51 and the counter electrode 52 is designed in such a manner that the distance between the substrate 90 and the counter electrode 52 is in the range of 1 mm to 20 mm. The support electrodes 51 are arranged in such a manner that adjacent substrates 90 are separated by a distance of 10 mm or less (e.g., 5 mm). The area of the counter electrode 52 is set in such a manner that a DLC film has a hardness of 10 GPa or more and that a coating region of each of the substrates 90 supported by the support electrodes 51 does not reach adjacent substrate 90.

The chamber 12 is formed of a stainless-steel plate so as to surround all the film deposition units 54. The chamber 12 includes a gas inlet 13 through which hydrogen gas, helium gas, tetramethylsilane gas, methane gas, and other gases can be fed into the chamber 12 and includes a gas outlet 14 connected to the vacuum pump 11 and used to regulate the pressure in the chamber 12 by operation of the vacuum pump 11. The gas inlet 13 is connected to the counter electrodes 52 of the film deposition units 54 through pipes. The gas outlet 14 is arranged on the bottom of the chamber 12.

The pulsed power supply 60 includes the electric circuits 62 used for the respective film deposition units 54. The electric circuits 62 are circuits configured to apply a DC pulse voltage between the support electrodes 51 and the counter electrodes 52 of the film deposition units 54. Fig. 2 is an explanatory drawing showing one film deposition unit 54 of the DLC-film deposition apparatus 10. As shown in Fig. 2, the electric circuit 62 includes a primary winding circuit 44 and a secondary winding circuit 50. The primary winding circuit 44 includes an inductor 30, a first semiconductor switch 32, and a second semiconductor switch 34 that are connected in series between both terminals of a DC power supply unit 28. The DC power supply unit 28 includes a DC power supply 24 and a capacitor 26 that reduces a high-frequency impedance. The secondary winding circuit 50 includes a coil element 48 located outside the chamber 12 and connected in series between the support electrode 51 and the counter electrode 52. In the primary winding circuit 44, the inductor 30 has one terminal connected to an anode terminal 32A of the first semiconductor switch 32 and the other terminal connected to a gate terminal 32G serving as a control terminal of the first semiconductor switch 32 through a diode 42. The diode 42 has an anode connected to the gate terminal 32G of the first semiconductor switch 32. In this case, an SI thyristor which has a significantly large tolerance to the rate of increase in voltage, i.e., (dv/dt), on being turned off and which has a high voltage rating is used as the first semiconductor switch 32. A power MOSFET 38 including an avalanche diode 36 in inverse-parallel connection is used as the second semiconductor switch 34. The second semiconductor switch 34 includes the power MOSFET 38 and a gate-driving circuit 40 which is connected to a gate terminal 38G and a source terminal 38S of the power MOSFET 38 and which controls the ON-OFF state of the power MOSFET 38. The inductor 30 of the primary winding circuit 44 constitutes a primary winding, and the coil element 48 of the secondary winding circuit 50 constitutes a secondary winding, so that they function as a transformer. A drain terminal 38D of the power MOSFET 38 is connected to a cathode terminal 32K of the first semiconductor switch 32.

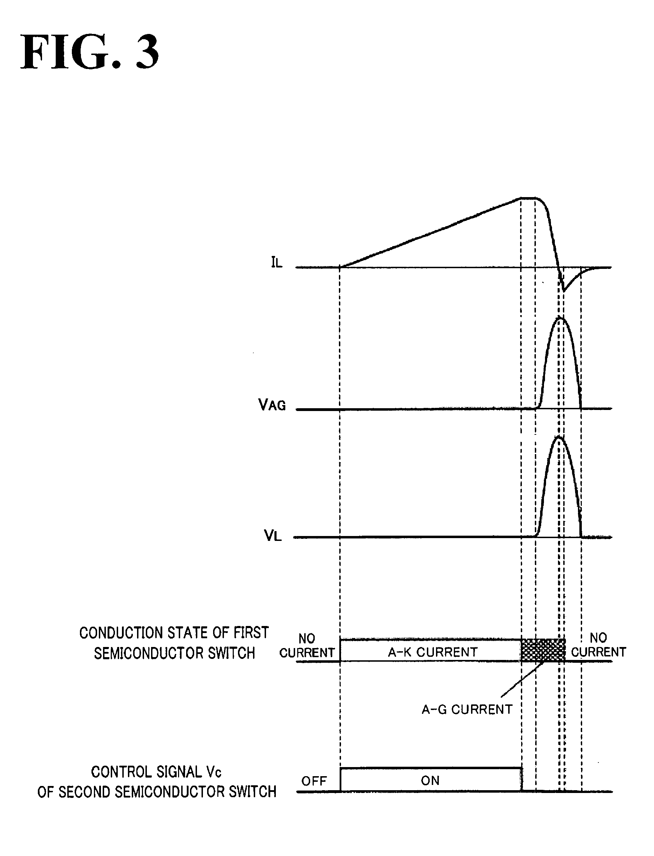

A mechanism for the generation of a pulse voltage in the primary winding circuit 44 of each of the electric circuits 62 will be described below. When the gate driving circuit 40 applies a control signal Vc between the gate and source of the power MOSFET 38, the power MOSFET 38 is turned on from an off state. At this point, the first semiconductor switch 32 is turned on by a field effect caused by applying a positive voltage between the gate terminal 32G and cathode terminal 32K thereof because of a significantly large impedance provided in opposite polarity by the diode 42. Thereby, a current flows between the anode terminal 32A and the cathode terminal 32K (A-K current).
In this way, a current flows through the first and second semiconductor switches 32 and 34, so that a voltage substantially equal to a voltage E of the DC power supply 24 is applied to the inductor 30, thereby storing a desired amount of energy. After the desired amount of energy is obtained, the gate driving circuit 40 stops sending the control signal Vc to turn off the power MOSFET 38. When the power MOSFET 38 is turned off, a pulse voltage is generated at the inductor 30. Specifically, when the second semiconductor switch 34 is turned off, the current IL of the inductor 30 is commutated to the path from the anode terminal 32A of the first semiconductor switch 32 to the cathode of the diode 42 through the gate terminal 32G and the anode of the diode 42, so that a current flows between the anode terminal 32A and the gate terminal 32G (A-G current). A current due to the energy stored in the inductor 30 keeps flowing from the anode terminal 32A to the gate terminal 32G, allowing the first semiconductor switch 32 to shift to an off state. Thus, a voltage VAG between the anode and gate of the first semiconductor switch 32 and a voltage VL between the terminals of the inductor 30 sharply increase. When the current IL reaches zero, the voltage VAG is maximized. Then the first semiconductor switch 32 is turned off to allow the diode 42 to shift to an off state, sharply reducing the voltage VAG. This is shown in Fig. 3. In FIG. 3, the current IL is a current that flows through the inductor 30, the voltage VAG is a voltage between the anode and gate of the first semiconductor switch 32, and the voltage VL is a voltage between the terminals of the inductor 30. The detailed mechanism of a pulse voltage is described in, for example, Japanese Patent No. 3811681.

A case where DLS films are simultaneously formed on the plural substrates 90 composed of an iron-based material (e.g., a SUS material, an SKD material, or an SKH material) having a lower volume resistivity than silicon with the DLC-film deposition apparatus 10 will be described below. First, the substrates 90 are rinsed. That is, the same number of the substrates 90 as the film deposition units 54 is prepared, and the substrates 90 are rinsed with an organic solvent (e.g., acetone) and then placed on the respective support electrodes 51. Subsequently, the substrates 90 are subjected to surface modification. The surface modification is treatment to remove organic substances and oxide films. Here, a DC pulse voltage is applied between the support electrodes 51 and the counter electrodes 52 of the film deposition units 54 by the electric circuits 62. The chamber 12 is evacuated by the vacuum pump 11 through the gas outlet 14 to achieve a pressure of 173.3 hPa (130 Torr). Helium gas and hydrogen gas are allowed to flow through the gas inlet 13 and ejected toward the substrates 90. Next, intermediate layers are formed on the substrates 90. The formation of the intermediate layers is performed in order that DLC films to be formed may not be easily detached from the substrates 90. Here, a DC pulse voltage is applied between the support electrodes 51 and the counter electrodes 52 of the film deposition units 54 by the electric circuits 62. The chamber 12 is evacuated by the vacuum pump 11 through the gas outlet 14 to achieve a pressure of 173.3 hPa (130 Torr). Helium gas and tetramethylsilane gas are allowed to flow through the gas inlet 13 and ejected toward the substrates 90. In this case, the resulting films are silicon carbide films.

Next, DLC films are formed on the intermediate layers provided on the substrates 90. The chamber 12 is evacuated by the vacuum pump 11 through the gas outlet 14 to achieve a pressure of 133 Pa (1 Torr) or less. Then helium gas is fed from the gas inlet 13 into the chamber 12 through the counter electrodes 52. Helium gas is fed until the internal pressure of the chamber 12 reaches a predetermined pressure in the range of 100 hPa to atmospheric pressure. Next, a DC pulse voltage is applied between the support electrodes 51 and the counter electrodes 52 while a mixed gas of methane gas and helium gas is being fed from the gas inlet 13 into the chamber 12 through the counter electrodes 52. That is, a DC pulse voltage is generated across the coil element 48 of the secondary winding circuit 50 by the primary winding circuits 44 of the electric circuits 62. The generated DC pulse voltage is applied between the support electrodes 51 and the counter electrodes 52 to generate a plasma between the electrodes 51 and 52, thereby forming DLC films on the substrates 90. Here, if an arc discharge occurs in one of the film deposition units 54 to which the DC pulse voltage is applied, the film that is being formed between the electrodes of the film deposition unit 54 is highly likely to be perforated. However, in the remaining film deposition units 54 arranged in the chamber 12, a DC pulse voltage is applied by the individual electric circuits 62; hence, film deposition is continued. In this way, even if an arc discharge occurs in any film deposition unit 54, the film deposition in the other film deposition units 54 is not affected. In the case of applying a DC pulse voltage between the support electrodes 51 and the counter electrodes 52 on the formation of the DLC films, the application of an electric power of 75 W/cm² or more per unit area of each of the counter electrodes 52 to the film deposition units 54 increases the deposition rate and is thus preferred.

Here, the correspondence between the components of this embodiment and components of the present invention is described. The DLC-film deposition apparatus 10 of this embodiment corresponds to a film-deposition apparatus of the present invention. A space surrounded by the chamber 12 corresponds to an enclosed space. The electric circuits 62 of the pulsed power supply 60 correspond to individual power supplies. The vacuum pump 11 corresponds to a pressure regulating unit.

According to the DLC-film deposition apparatus 10 described in detail above, products obtained by covering the substrates 90 composed of an iron-based material with the DLC films are mass-produced in high yield. Furthermore, predetermined films are formed at a pressure in the range of 100 hPa to atmospheric pressure; hence, a higher film deposition rate is obtained than that at a pressure of less than 100 hPa. Thus, a larger number of workpieces covered per unit time can be achieved. This point will be described in detail in examples. Moreover, each of the counter electrodes 52 has the nozzle with a diameter of 1 mm to 4 mm, thereby easily resulting in a uniform in-plane thickness distribution of each DLC film. This point will also be described in detail in examples. In addition, the distance between the substrates 90 and the counter electrodes 52 is 1 mm to 20 mm, thereby easily maintaining a discharge suitable for plasma-enhanced CVD, which is suitable for mass production.

The present invention is not limited to the foregoing embodiment. It is understood that various changes may be made without departing from the scope of the invention.

For example, in the foregoing embodiment, the DLC-film deposition apparatus 10 is defined as an apparatus configured to simultaneously cover the plural substrates 90 with the DLC films at a pressure of 100 hPa to atmospheric pressure. Alternatively, the DLC-film deposition apparatus 10 may be an apparatus configured to simultaneously cover the plural substrates 90 with the DLC films at a pressure of 10 hPa to atmospheric pressure. Specifically, after the intermediate layers are formed on the substrates 90, the chamber 12 is evacuated by the vacuum pump 11 through the gas outlet 14 to achieve an internal pressure of 133 Pa (1 Torr) or less. Subsequently, helium gas is fed from the gas inlet 13 into the chamber 12 through the counter electrodes 52. Helium gas may be fed until the internal pressure of the chamber 12 reaches a predetermined pressure in the range of 10 hPa to atmospheric pressure. In this case, the application of an electric power of 150 W/cm² or more per unit area of each of the counter electrodes 52 to the film deposition units 54 during film deposition increases the deposition rate and is thus preferred.

In the above-described embodiment, the support electrodes 51 and the counter electrodes 52 are composed of an iron-based material. Alternatively, they may be composed of a metal material other than the iron-based material. In this case, it is also possible to cover the plural substrates 90 with DLC formed in good yield with the transfer of ions in a plasma.

In the above-described embodiment, the present invention is applied to the DLC-film deposition apparatus 10 for forming a DLC film. Alternatively, the present invention may be applied to a film-deposition apparatus for forming a boron nitride (BN) film and a cubic boron nitride (c-BN) film. In this case, for example, BCl₃ (boron chloride) and NH₃ (ammonia) gases are ejected instead of the ejection of methane gas from the nozzle 52a.

In the above-described embodiment, one substrate 90 is covered with the DLC film in each of the film deposition units 54. Alternatively, a plurality of substrates may be covered with the DLC films in each of the film deposition units 54. That is, the plural substrates may be covered with DLC films formed by arranging the plural substrates on the support electrode 51 of each of the film deposition units 54 and then generating a plasma between the support electrode 51 and the counter electrode 52.

In the above-described embodiment, one support electrode 51 is arranged in each of the film deposition units 54. Alternatively, one large support electrode may be shared with the plural film deposition units 54 in the chamber 12 because each of the support electrodes 51 is grounded and has the same potential.

In the above-described embodiment, the DLC films are formed on the substrates 90. Alternatively, the workpieces on which the DLC films are formed are not limited to the substrates 90. For example, cutting tools and automotive components composed of metals and having any shape other than a plate-like shape may be used.

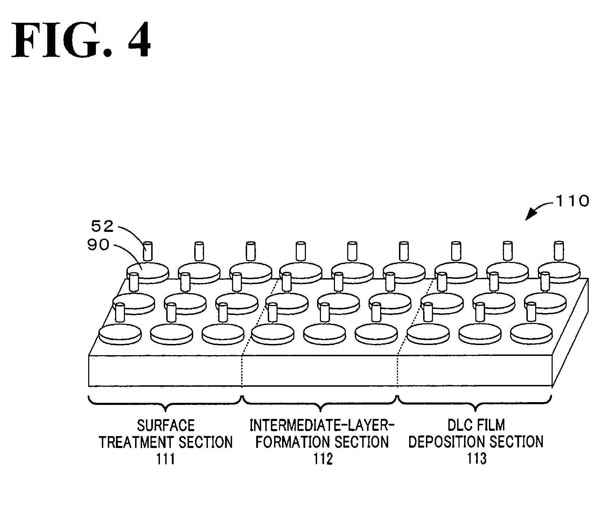

In the above-described embodiment, after the substrates 90 are placed, the surface modification, the formation of the intermediate layers, and the formation of the DLC films are performed in one chamber 12. Alternatively, after the substrates 90 are placed, the surface modification, the formation of the intermediate layers, and the formation of the DLC films may be performed in different chambers. For example, a DLC-film deposition apparatus 110 as shown in Fig. 4 may be used. Fig. 4 schematically illustrates configuration of the DLC-film deposition apparatus 110. The DLC-film deposition apparatus 110 includes a surface-treatment section 111 where the plural substrates 90 are placed and subjected to surface treatment, an intermediate-layer-formation section 112 where the intermediate layers are formed, a DLC-film-deposition section 113 where the DLC films are formed, and a robot arm, not shown, configured to transfer the substrates 90 between the sections. Although, in fact, the surface-treatment section 111, the intermediate-layer-formation section 112, and the DLC-film-deposition section 113 have the same configuration as that of the DLC-film deposition apparatus 10, the substrates 90 and the counter electrodes 52 alone are shown for convenience of illustration. The substrates 90 may be transferred by a transport mechanism, e.g., a transport belt, other than the robot arm, in place of the robot arm (not shown).

To form DLC films with the DLC-film deposition apparatus 110, the plural substrates 90 are rinsed with an organic solvent (e.g., acetone) and placed in the surface-treatment section 111. The substrates 90 are subjected to surface modification. In the surface-treatment section 111, the same treatment as that in the DLC-film deposition apparatus 10 described above is performed to modify the surfaces of the substrates 90. Next, the substrates 90 that have been subjected to surface modification are transferred by the robot arm (not shown) to the intermediate-layer-formation section 112. In the intermediate-layer-formation section 112, the substrates 90 are heated with the ceramic heaters 53 and then subjected to the same treatment as that in the DLC-film deposition apparatus 10 described above, thereby forming intermediate layers on the substrates 90. Subsequently, the substrates 90 on which the intermediate layers have been formed are transferred by the robot arm (not shown) to the DLC-film-deposition section 113. In the DLC-film-deposition section 113, the substrates 90 are heated with the ceramic heaters 53 and then subjected to the same treatment as that in the DLC-film deposition apparatus 10 described above, thereby forming DLC films on the substrates 90. In this way, the substrates 90 are subjected to these treatments and transferred by the robot arm (not shown), thereby forming the DLC films on the plural substrates.

### Examples

### Example 1

In the DLC-film deposition apparatus 10, each of the counter electrodes 52 was a cylindrical member composed of SUS304, having a height of 50 mm and an outside diameter of 15 mm, and having the nozzle 52a with a diameter of 2 mm. Each of the support electrodes 51 was composed of SUS304 and had a thickness of 2 mm and a plurality of holes each having a diameter of 1 mm. The distance between each substrate 90 and a corresponding one of the counter electrodes 52 was set to 5 mm. First, five substrates 90 composed of SUS440C and each having a diameter of 30 mm and a thickness of 5 mm were prepared and rinsed with acetone. Each of the substrates 90 was placed on a corresponding one of the support electrodes 51 so as to face a corresponding one of the counter electrodes 52 in the chamber 12. Subsequently, the substrates 90 were heated to 150°C with the ceramic heaters 53. A DC pulse voltage having a peak pulse voltage of 2.0 kV and a pulse width of 2 µsec was applied between the support electrodes 51 and the counter electrodes 52. The chamber 12 was evacuated by the vacuum pump 11 through the gas outlet 14 to achieve a pressure of 173.3 hPa (130 Torr). Helium gas and hydrogen gas were ejected from the gas inlet 13 toward the substrates 90 through the counter electrodes 52 at a helium-gas flow rate of 2800 sccm and a hydrogen-gas flow rate of 200 sccm for 3 minutes. Then a DC pulse voltage having a peak pulse voltage of 2.0 kV and a pulse width of 0.9 µsec was applied between the support electrodes 51 and the counter electrodes 52. The chamber 12 was evacuated by the vacuum pump 11 through the gas outlet 14 to achieve a pressure of 173.3 hPa (130 Torr). Helium gas and tetramethylsilane gas were ejected from the gas inlet 13 toward the substrates 90 through the counter electrodes 52 at a helium-gas flow rate of 2800 sccm and a tetramethylsilane-gas flow rate of 10 sccm for 1 minute.

Subsequently, helium gas was fed from the gas inlet 13 through the counter electrodes 52 in such a manner that the pressure in the chamber 12 reached 465.5 hPa (350 Torr). A DC pulse voltage having a peak pulse voltage of 2.0 kV and a pulse width of 0.9 µsec was applied between the support electrodes 51 and the counter electrodes 52. Methane gas and helium gas were ejected from the gas inlet 13 toward the substrates 90 through the counter electrodes 52 at a helium-gas flow rate of 2800 sccm and a methane-gas flow rate of 40 sccm for 3 minutes. That is, a DC pulse voltage was generated across the coil elements 48 of the secondary winding circuits 50 by the primary winding circuits 44 of the electric circuits 62. As a result, DLC films were formed on the substrates 90.

Spectral analysis of the resulting DLC films with a Raman spectrometer (NRS-1000, manufactured by JASCO Corporation) demonstrated that a circular region with a diameter of 20 mm each of the DLC films was a satisfactory DLC film. The hardness and elastic modulus of each of the resulting DLC films were measured using a thin-film mechanical property evaluation apparatus (Nano Indenter XP, manufactured by MTS Systems Corporation). The results demonstrated that each film had a hardness as high as 20 GPa and an elastic modulus of 180 GPa.

In each of the DLC-film deposition apparatus 10 (with a configuration in which each of the five electric circuits 62 applied a DC pulse voltage to a corresponding one of the five counter electrodes 52) according to this example and a DLC-film deposition apparatus, according to a comparative example, having the same configuration as this example, except that one electric circuit applied a DC pulse voltage to five counter electrodes, an experiment in which DLC films were simultaneously formed on five substrates 90 was performed 10 times. In this case, among the five substrates 90, the rate of the substrates 90 on which the DLC films had been successfully formed, in other words, the yield of the DLC films in one deposition operation, was shown in Table 1. In the DLC-film deposition apparatus according to this comparative example, the rate was either 0% or 100%. In contrast, in the DLC-film deposition apparatus according to this example, the rate was 60%, 80%, or 100%, and the rate was not 0%. The results demonstrated that the DLC-film deposition apparatus according to this example provided better yields.

**Table 1**

| EXPERIMENT NUMBER | 1st | 2nd | 3rd | 4th | 5th | 6th | 7th | 8th | 9th | 10th |
|---|---|---|---|---|---|---|---|---|---|---|
| ONE COMMON ELECTRICAL CIRCUIT | 100 | 0 | 100 | 0 | 0 | 0 | 100 | 0 | 100 | 100 |
| FIVE INDIVIDUAL ELECTRIC CIRCUIT | 100 | 80 | 100 | 100 | 80 | 60 | 100 | 100 | 100 | 100 |

| | | | | | | | | | | |
|---|---|---|---|---|---|---|---|---|---|---|
| RATE OF SUCCESSFUL FORMATION OF DLC FILMS (%) | | | | | | | | | | |

Next, various model experiments using one film deposition unit 54 were performed. As shown in Table 2, the distance between the substrate 90 and the counter electrode 52 was changed. In each distance, a voltage at which a plasma discharge was initiated was measured by gradually changing the peak voltage of a DC pulse voltage applied between the electrodes. Except for these points, the experiment was performed under the same conditions as those of the film deposition unit 54 in Example 1. A distance between the counter electrode 52 and the substrates 90 of 1 mm to 20 mm gave satisfactory results. At a distance of less than 1 mm, a glow discharge occurred at a low voltage but shifted to an arc discharge, so that a film was not formed. At a distance exceeding 20 mm, a glow discharge did not occur readily.

**Table 2**

| | | | | | | | |
|---|---|---|---|---|---|---|---|
| DISTANCE BETWEEN SUBSTRATE 0.5 AND COUNTER ELECTRODE (mm) | 0.5 | 1 | 5 | 10 | 15 | 20 | 25 |
| PEAL VOLTAGE (Kv) | 0.7 | 1.5 | 2.0 | 5.0 | 8.2 | 13 | 15.5 |

An experiment was performed under the same conditions as those of the film deposition unit 54 in Example 1, except that the diameter of the nozzle 52a and the number of nozzles were changed as shown in Table 3 and that the ejection time to form DLC films was set to 5 minutes. As shown in Table 3, a diameter of the nozzle of 1 mm to 4 mm resulted in small variations in in-plane thickness distribution. At a diameter of the nozzle of 5 mm or more, variations in in-plane thickness distribution were sharply increased. Here, the in-plane thickness distribution was determined by measuring the thicknesses at 10 points equidistantly spaced on the substrate with a surface roughness tester (Form Talysurf S5, manufactured by Taylor Hobson Ltd). Specifically, the thicknesses were first measured, and the mean value of the measurement values at the 10 points was calculated. Next, differences between the mean value and the measurement values were determined by subtracting the measurement values at the measurement points from the mean value. Among these differences, the maximum value and the minimum value were determined. A value obtained by subtracting the minimum value from the maximum value was divided by the mean value and then multiplied by 100 to give a value, which was defined as the in-plane thickness distribution (in units of %). Although each of the resulting film deposition regions was formed as a circular region with a diameter of 20 mm, the evaluation was made in a circular region with a diameter of 16 mm excluding a portion extending between the circumference and a position 2 mm from the circumference.

**Table 3**

| | | | | | | | | |
|---|---|---|---|---|---|---|---|---|
| DIAMETER OF NOZZLE (mm) | 1 | 1 | 1 | 2 | 3 | 4 | 5 | 6 |
| NUMBER OF NOZZLES | 1 | 2 | 3 | 1 | 1 | 1 | 1 | 1 |
| IN-PLANE THICKNESS DISTRIBUTION (%) | 3 | 3 | 3 | 5 | 7 | 10 | 40 | 60 |

An experiment was performed under the same conditions as those of the film deposition unit 54 in Example 1, except that the pressure in the chamber 12 during deposition was adjusted as shown in Table 4. A pressure in the chamber 12 of 1.33 hPa (1 Torr) to 1010.8 hPa (760 Torr) resulted in the DLC films each having a hardness of 20 GPa or more. A pressure in the chamber 12 of less than 1.33 hPa (1 Torr) resulted in the DLC films each having a hardness as low as 10 GPa or less. Furthermore, it was found that a higher pressure had a tendency to lead to a reduction in the diameter of each film deposition region and that a higher pressure had a tendency to lead to an increase in film deposition rate. In particular, a film deposition rate as high as 0.18 µm/min or more, which was suitable for mass production, was obtained at a pressure in the chamber 12 of 133 hPa (100 Torr) or more. Here, each of the substrates had a diameter of 30 mm. In the case where a diameter of each film deposition region exceeded 30 mm, a larger diameter of each film deposition region required a larger distance between adjacent substrates in order to avoid the influence of adjacent plasmas. An electric power of 75 W/cm² per unit area of each of the counter electrodes 52 was applied to the film deposition units 54.

**Table 4**

| PRESSURE (hPa) (Torr) | 0. 0133 | 0. 665 | 1. 33 | 13.3 | 133 | 465.5 | 1010.8 |
|---|---|---|---|---|---|---|---|
| | (0.01) | (0.5) | (1) | (10) | (100) | (350) | (760) |
| DIAMETER OF FILM DEPOSITION REGION (mm) | 150 | 135 | 100 | 45 | 30 | 20 | 15 |
| FILM DEPOSITION RATE (µm/min) | 0. 005 | 0.04 | 0.07 | 0. 12 | 0.18 | 0.25 | 0.35 |
| DISTANCE BETWEEN ADJACENT SUBSTRATES (mm) | 120 | 105 | 70 | 15 | 5 | 5 | 5 |
| HARDNESS (GPa) | 8.0 | 9.0 | 20.0 | 20.5 | 22.5 | 22.0 | 20.0 |

Subsequently, an experiment was performed under the same conditions as those of the film deposition unit 54 in Example 1, except that the pressure in the chamber 12 during deposition and the diameter of the lower surface of each of the counter electrodes 52 were changed as shown in Table 5. The diameters of the film deposition regions were shown in Table 5. The results demonstrated that a higher pressure in the chamber 12 had a tendency to lead to a reduction in the diameter of each film deposition region and that a larger diameter of the lower surface of each counter electrode had a tendency to lead to an increase in the diameter of each film deposition region. Thus, in the case where the entire surface of each of the plural substrates is covered with DLC films, the diameter of each film deposition region is determined in such a manner that the following requirements are satisfied: the diameter of each film deposition region is slightly larger than the diameter of a corresponding one of the substrates, and the distance between adjacent substrates is small. Here, with respect to the requirements, the diameter of the film deposition region was determined to be 10% to 50% larger than the diameter of the substrate. A diameter of the film deposition region within a range satisfying the requirements is chosen from Table 5, and then a combination of the pressure and the diameter of the lower surface of the counter electrode are selected. In the case where several alternatives are provided, a combination of a higher pressure to achieve a higher film deposition rate and a diameter is preferably selected as values used for the formation of actual DLC films in view of mass production. For example, when the substrate has a diameter of 30 mm, the film deposition region has a diameter of 33 mm to 45 mm according to the requirements. Shaded cells in Table 5 indicate combinations satisfying the requirements. Among these, the highest-pressure combination is a combination of a pressure of 133 hPa (100 Torr) and a diameter of the lower surface of the counter electrode of 20 mm as shown in a cell surrounded by a double line. Thus, this combination is preferably selected as values used for the formation of actual DLC films.

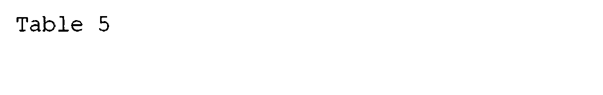

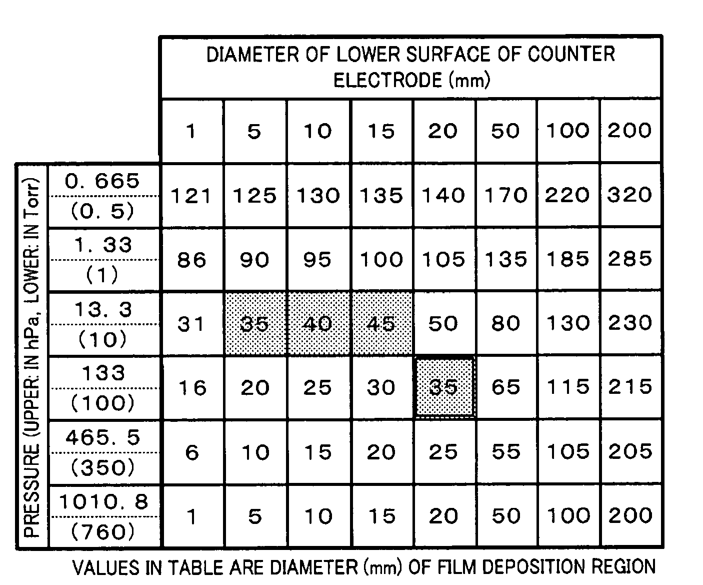

An experiment was performed under the following conditions: The pressure in the chamber 12 during deposition was adjusted as shown in Table 6. Except for this, the same conditions as those of the film deposition units 54 in Example 1 were used. Furthermore, an electric power of 150 W/cm² or more per unit area of each of the counter electrodes 52 was applied to the film deposition units 54. Except for this, the same conditions as those of the pulsed power supply 60 in Example 1 were used. Here, an electric power that was twice the electric power applied in the experiment shown in Table 4 was applied to the film deposition units 54 by doubling the pulse repetition frequency of a pulse voltage generated by the pulsed power supply 60. A pressure in the chamber 12 of 1.33 hPa (1 Torr) to 1010.8 hPa (760 Torr) resulted in the DLC films each having a hardness of 20 GPa or more. A pressure in the chamber 12 of less than 1.33 hPa (1 Torr) resulted in the DLC films each having a hardness as low as 10 GPa or less. Furthermore, it was found that a higher pressure had a tendency to lead to a reduction in the diameter of each film deposition region and that a higher pressure had a tendency to lead to an increase in film deposition rate. In particular, a film deposition rate as high as 0.30 µm/min or more, which was more suitable for mass production, was obtained at a pressure in the chamber 12 of 13.3 hPa (10 Torr) or more. Furthermore, the experimental results shown in Tables 4 and 6 demonstrated that a higher electric power applied to the film deposition units 54 resulted in a film deposition rate suitable for mass production even at a lower pressure in the chamber 12.

**Table 6**

| PRESSURE (hPa) (Torr) | 0.133 | 0. 665 | 1.33 | 13.3 | 133 | 465.5 | 1010.8 |
|---|---|---|---|---|---|---|---|
| | (0.01) | (0.5) | (1) | (10) | (100) | (350) | (760) |
| DIAMETER OF FILM DEPOSITION REGION (mm) | 150 | 135 | 100 | 45 | 30 | 20 | 15 |
| FILM DEPOSITION RATE (µm/min) | 0.01 | 0.07 | 0.121 | 0.30 | 0.45 | 0.58 | 0.83 |
| DISTANCE BETWEEN ADJACENT SUBSTRATES (mm) | 120 | 105 | 70 | 15 | 5 | 5 | 5 |
| HARDNESS (GPa) | 8.0 | 9.0 | 20.2 | 21.5 | 22.7 | 22.8 | 21.0 |

The present application claims priority from Japanese Patent Application No. 2008-247728 filed on September 26, 2008, the entire contents of which are incorporated herein by reference.

### Industrial Applicability

The present invention is applicable in, for example, forming DLC films as protective films for various components.

## Claims

1. A film deposition apparatus configured to cover a plurality of workpieces composed of a metal material having a lower volume resistivity than silicon with predetermined films that are formed together with the transfer of ions in a plasma, the apparatus comprising:
film deposition units each including a support electrode that supports the respective workpieces and serves as one electrode for generating the plasma, and including a counter electrode that is provided apart from the support electrode to face the support electrode and serves as the other electrode for generating the plasma;
an enclosed space in which the plural film deposition units are arranged; and
individual power supplies that are provided for the respective film deposition units and apply a voltage between the support electrodes and the counter electrodes.

2. The film deposition apparatus according to Claim 1, further comprising:
a pressure regulating unit for regulating a pressure in the enclosed space,
wherein the individual power supplies apply a voltage between the support electrodes and the counter electrodes of the film deposition units to generate plasmas while pressure in the enclosed space is regulated in the range of 10 hPa to atmospheric pressure by the pressure regulating unit, so as to cover the plural workpieces with the predetermined films.

3. The film deposition apparatus according to Claim 2, wherein the individual power supplies apply a voltage between the support electrodes and the counter electrodes of the film deposition units to generate plasmas while the pressure in the enclosed space is regulated in the range of 100 hPa to atmospheric pressure by the pressure regulating unit, so as to cover the plural workpieces with the predetermined films.

4. The film deposition apparatus according to any one of Claims 1 to 3, wherein the counter electrode of the film deposition unit has a nozzle that has a diameter of 1 mm to 4 mm and ejects a gas as a source of the predetermined films toward a corresponding one of the workpieces.

5. The film deposition apparatus according to any one of Claims 1 to 4, wherein the support electrode of the film deposition unit supports a corresponding one of the workpieces in such a manner that the distance between the workpiece and a corresponding one of the counter electrodes is in the range of 1 mm to 20 mm.

6. The film deposition apparatus according to any one of Claims 1 to 5, wherein the predetermined films are DLC films.

7. The film deposition apparatus according to any one of Claims 1 to 6, wherein the workpieces are composed of an iron-based material.

8. The film deposition apparatus according to Claim 7, wherein the workpieces are composed of SUS material, SKD material, or SKH material.

9. The film deposition apparatus according to any one of Claims 1 to 8, wherein the individual power supplies apply a DC pulse voltage between the support electrodes and the counter electrodes.
